## Europäisches Patentamt
## European Patent Office
## Office européen des brevets

(11) Veröffentlichungsnummer: **0 383 139 B1**

(12) **EUROPÄISCHE PATENTSCHRIFT**

(45) Veröffentlichungstag der Patentschrift: **18.05.94**

(21) Anmeldenummer: **90102228.5**

(22) Anmeldetag: **05.02.90**

(51) Int. Cl.5: **G01R 31/06**

(54) Verfahren und Vorrichtung zur Prüfung von Spulen auf Windungs- und/oder Lagenschluss.

(30) Priorität: **15.02.89 DE 3904554**

(43) Veröffentlichungstag der Anmeldung:
**22.08.90 Patentblatt 90/34**

(45) Bekanntmachung des Hinweises auf die Patenterteilung:
**18.05.94 Patentblatt 94/20**

(84) Benannte Vertragsstaaten:
**AT CH DE FR GB IT LI SE**

(56) Entgegenhaltungen:
**DE-B- 1 041 154**
**DE-C- 910 092**
**FR-A- 2 365 806**
**GB-A- 2 192 464**

**IBM TECHNICAL DISCLOSURE BULLETIN,**
**Band 21, Nr. 6, November 1978, Seiten**
**2503-2504, New York, US; H.D. NUSBAUM:**
**"Voice coil short detector"**

(73) Patentinhaber: **SIEMENS AKTIENGESELL-SCHAFT**
**Wittelsbacherplatz 2**
**D-80333 München(DE)**

(72) Erfinder: **Trampert, Wolfgang**
**Joh.-Seb.-Bach-Strasse 3**
**D-8523 Baiersdorf(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Windungs- und/oder Lagenschlußprüfverfahren für Spulen, bei dem durch eine Erregerwicklung in einem Erregerkreis in die zu prüfende Spule (Prüfling) eine erste Spannung induziert wird, wobei das von einer Windung mit Windungsschluß durch den darin fließenden Kurzschlußstrom erzeugte Streufeld in eine Meßspule eines Meßkreises eine zweite Spannung induziert, deren Wert und/oder Phase gegenüber einem Vergleichswert ermittelbar ist, wobei die Messung bei einer solchen Frequenz, bei der die Spannung bei fehlerfreiem Prüfling Null ist, ausgeführt wird. Daneben bezieht sich die Erfindung auch auf die zugehörige Vorrichtung zur Durchführung des Verfahrens, mit einem ersten Schenkelkern mit einer Erregerwicklung und mit einem weiteren Schenkelkern mit einer Meßwicklung und daran angeschlossener Anzeigeeinrichtung in derartiger Anordnung, daß die Schenkel der beiden Schenkelkerne von der zu prüfenden Wicklung umgreifbar sind, wobei beide Schenkelkerne jeweils durch ein Joch schließbar sind und zwischen den Schenkelkernen und dem sie jeweils schließenden Joch ein Luftspalt besteht.

Spulen für elektrotechnische Anwendungen werden heute durchweg in Massenfertigung gewickelt. Da die lackisolierten Drähte Fehler aufweisen können, ist das Auftreten eines Windungs- oder gar Lagenschlusses nicht ausgeschlossen. Bei der Fertigung unerkannt gebliebener Windungsschlüsse können unter Umständen zu einem Langzeitausfall der Spule führen. Daher ist es notwendig, die fertig gewickelten Spulen im Rahmen der Qualitätssicherung einer Prüfung auf Windungs- und/oder Lagenschluß zu unterziehen, wozu Meßverfahren nach unterschiedlichsten physikalischen Prinzipien möglich sind.

In der Praxis sind bisher Meßverfahren üblich, die beispielsweise nach dem Prinzip einer Wechselspannungsmeßbrücke oder nach dem Stoßspannungsprüfverfahren arbeiten. Nach diesem Prinzip realisierte Meßgeräte arbeiten bei Spulen mit geringeren Windungszahlen zufriedenstellend. Bei Spulen höherer Windungszahl liefern die bekannten Geräte aber aufgrund der parasitären Spulenkapazität bzw. wegen der des geringen Meßeffektes, den ein Windungsschluß verursacht, keine sicheren Ergebnisse mehr.

Aus der GB-A-21 92 464 ist eine Anordnung zum Testen von Spulenbauteilen bekannt, bei der ein Bauteil in einer Kontaktiereinrichtung über eine Schaltmatrix alternativ an eine Meßvorrichtung für den induktiven und ohmschen Widerstand, an einen Isolationsester oder an ein Spannungsmeßgerät anschließbar ist und die Meßsignale computergestützt ausgewertet werden. Jedes Bauteil, beispielsweise eine Spule, muß dazu mit seinen Anschlüssen kontaktiert werden, so daß der Einsatzbereich der vorbekannten Anordnung begrenzt ist.

Aufgrund ständig höher werdender Anforderungen an Spulen sollen Windungsschlüsse über eine Windung, insbesondere auch bei Spulen mit sehr hohen Windungszahlen, sicher erkannt werden. Dabei sollen derartige Meßverfahren auch ohne Kontaktierung der Spulenanschlüsse möglich sein, so daß sie für den Einsatz bei einer flexiblen Massenfertigung von Spulen geeignet sind.

Aus der DE-C-910 092 ist eine Einrichtung zum Prüfen von Spulen auf Kurzschlußwindungen bekannt, bei der zwei Hilfsspulen, von denen die eine an eine Wechselstromquelle, die andere an einen Spannungsmesser angeschlossen ist, magnetisch, vorzugsweise mittels zweier Eisenkerne, mit der zu prüfenden Spule gekoppelt sind. Dabei wird mit technischem Wechselstrom (50 Hz) gearbeitet, wobei der Spannungsmesser unmittelbar in Kurzschlußwindungen geeicht werden soll.

Weiterhin ist aus der FR-A-2 365 806 (DE-B-26 44 253) eine Einrichtung zur Prüfung einer Wicklung auf Windungs- oder Lagenschluß bekannt, die auch bei Wicklungen mit sehr hoher Windungszahl eine einwandfreie Prüfung auf Windungs- oder Lagenschluß zulassen soll: Dabei wird mit einem Schenkelkern mit einer Erregerwicklung und mit einem weiteren Schenkelkern mit einer Meßwicklung und einer daran angeschlossenen Anzeigeeinrichtung gearbeitet, wobei die Schenkel der beiden Schenkelkerne von der zu prüfenden Wicklung umgreifbar sind. In einer vorteilhaften Ausführungsform ist dabei auf den beiden Schenkelkernen eine Hilfswicklung aufgebracht und an die Hilfswicklung eine hinsichtlich der Phasenlage eines abgegebenen Stromes einstellbare Abgleicheinrichtung angeschlossen. Der Strom muß hierbei in Abhängigkeit vom Prüfling jeweils vorgegeben werden. In einer anderen Ausführungsform soll auf die Hilfswicklung verzichtet werden können, sofern die Meßeinrichtung selbst phasenempfindlich ist. In jedem Fall wird die Messung bei einer solchen Frequenz, bei der die Spannung in der Meßspule bei fehlerfreiem Prüfling Null ist, ausgeführt. Obwohl die Meßfrequenz höher als 50 Hz ist, wird angestrebt, diese so niedrig wie möglich zu halten.

Aufgabe der Erfindung ist es demgegenüber, ein Verfahren und die zugehörige Vorrichtung anzugeben, mit denen die Wicklungsprüfung verbessert werden kann. Insbesondere sollen keine manuellen Abgleichvorgänge erfolgen müssen bzw. keine phasenempfindliche Meßeinrichtung benötigt werden.

Die Aufgabe ist erfindungsgemäß bei einem Verfahren der eingangs genannten Art dadurch gelöst, daß die Meßfrequenz innerhalb eines prüflingstypspezifischen Meßbereichs liegt, der aus einem Frequenzspektrum zwischen etwa 500 Hz und etwa 100 kHz ermittelt wird, wobei die Meßfrequenz im Meßfrequenzbereich variiert und gleichzeitig die Spannung an der Meßspule aufgenommen wird, und daß jeweils der Wert der minimalen Spannung ausgewertet wird.

Im Rahmen der Erfindung konnte nachgewiesen werden, daß bei einer optimalen Meßfrequenz, die vom Spulentyp abhängt, sich das von der Erregerspule ausgehende Streufeld einerseits und das durch die Windungskapazität des Prüflings verursachte Streufeld andererseits gegenseitig in der Meßspule vollständig kompensieren. Da aber die durch Windungsschluß entstandene Komponente im Streufeld des Prüflings nicht durch das Streufeld der Erregerspule kompensiert werden kann, erhöht sich der Absolutwert der minimalen Spannung bei der erfindungsgemäß gewählten Meßfrequenz deutlich. Gegenüber dem Stand der Technik ist somit die Prüfschärfe erhöht, wobei sich durch Auswertung dieser Spannung eine eindeutige Aussage über das Vorliegen eines Windungs- und/oder Lagenschlusses machen läßt.

Bei der zugehörigen Vorrichtung der eingangs genannten Art bestehen die Schenkelkerne und die sie schließenden Joche aus Ferrit, sind Mittel vorhanden, die die Meßfrequenz variieren und gleichzeitig die Spannung an der Meßspule aufnehmen, und sind weitere Mittel vorgesehen, mit denen jeweils der Wert der minimalen Spannung der Meßspule ausgewertet wird.

Besonders vorteilhaft ist bei der Erfindung, daß sich durch geeignete Ausbildung des Meßsystems der Prüfvorgang automatisieren läßt. Insbesondere die Wahl der geeigneten Meßfrequenz erfolgt vollautomatisch durch entsprechende software-mäßige Ausgestaltung mittels eines Personalcomputers.

Eine Kontaktierung der Prüflinge ist bei der Erfindung nicht notwendig. Es hat sich gezeigt, daß es mit dem erfindungsgemäßen Verfahren und der zugehörigen Vorrichtung möglich ist, Windungsschlüsse über eine einzige Windung auch noch bei Spulen mit über 35.000 Wdg sicher zu erkennen. Dabei beträgt die erforderliche Prüfzeit etwa 2,5 s. In Abhängigkeit von der Prüfschärfe und geeigneter Wahl des gleichermaßen für die Auswertung verwendeten Personal-Computers läßt sich die Prüfzeit bis auf etwa 1 s vermindern.

Weitere Einzelheiten und Vorteile der Erfindung ergeben sich aus der nachfolgenden Figurenbeschreibung von Ausführungsbeispielen in Verbindung mit den weiteren Unteransprüchen.

Es zeigen

FIG 1 den Aufbau der beiden für die Prüfung notwendigen Magnetkreise,

FIG 2 ein Diagramm zur Erläuterung der Wahl der Meßfrequenz,

FIG 3 einen Ausschnitt aus FIG 2 für einen konkreten Spulen typ,

FIG 4 eine vorteilhafte Modifizierung der Magnetkreise gemäß FIG 1,

FIG 5 das Gesamtmeßsystem mit einem Personalcomputer zur Ablaufsteuerung der Messung sowie zur Auswertung der Meßdaten,

FIG 6 ein Flußdiagramm zur Verdeutlichung der vollautomatischen Ermittlung der Meßparameter und

FIG 7 ein Flußdiagramm zur Verdeutlichung der Serienprüfung.

Das hier vorgeschlagene Verfahren stellt ein modifiziertes Streufeld-Meßverfahren dar, bei dem die zu prüfende Spule (Prüfling) in an sich bekannter Weise zwischen zwei magnetische Kreise gebracht wird. Im ersten Kreis befindet sich eine Erregerspule und im zweiten Kreis eine Meßspule. Dabei werden folgende Effekte ausgenutzt: Das von der Sendespule, an die eine Wechselspannungsquelle angeschlossen ist, ausgehende Magnetfeld induziert im Prüfling eine Spannung. Gleichzeitig geht von der Sendespule ein Streufeld aus, das auch in der Meßspule eine Spannung erzeugt. Erhöht man die Erregerfrequenz, so macht sich die parasitäre Spulenkapazität des Prüflings immer stärker bemerkbar. Auch in einem fehlerfreien Prüfling fließt daher ein Strom, der seinerseits ein Magnetfeld hervorruft. Bei einer bestimmten Frequenz kompensieren sich aber die Streufelder, die durch die Sende- und Prüflingsspule entstehen, gegenseitig. Bei dieser Frequenz erreicht die Spannung in der Meßspule ihr Minimum. Diese Frequenz wird als Meßfrequenz gewählt. Liegt in der Prüflingsspule ein Windungsschluß vor, so geht von dem in dieser Windung fließenden Kurzschlußstrom ein Magnetfeld aus, das eine Wirkkomponente im Streufeld des Prüflingss verursacht. Letztere Wirkkomponente kann aber nicht von dem Streufeld der Erregerspule kompensiert werden. Daher erhöht ein Windungsschluß im Prüfling den Wert der minimalen Spannung, der bei der oben beschriebenen Frequenz in der Meßspule induziert wird. Die Auswertung dieser Spannung liefert die Aussage, ob ein Windungsschluß vorliegt oder nicht.

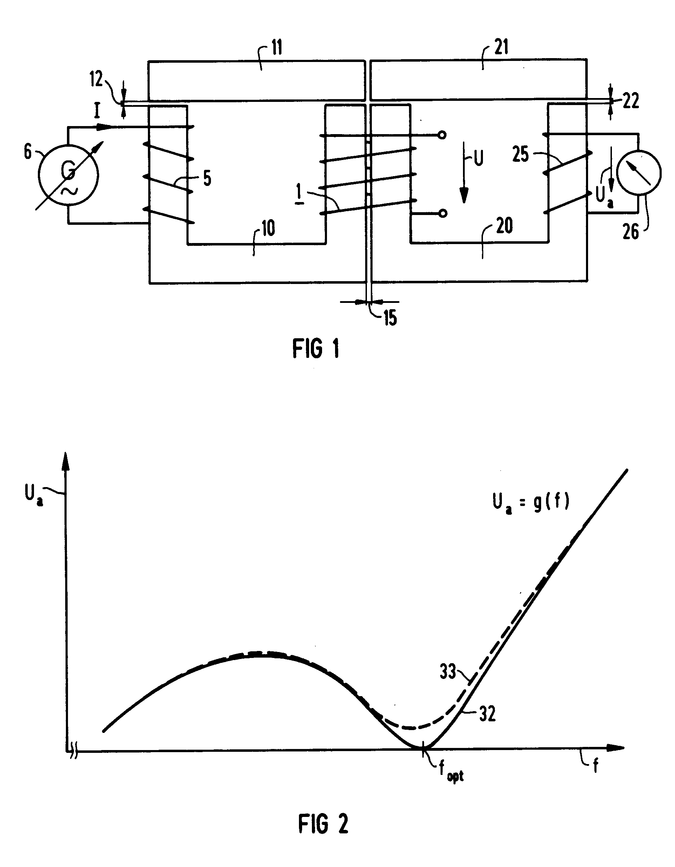

Die Meßanordnung gemäß FIG 1 besteht aus zwei U-förmigen Schenkelkernen 10 und 20, die je mit einem zugehörigen Joch 11 bzw. 21 einen geschlossenen Magnetkreis bilden. Die Schenkelkerne 10 bzw. 20 und die zugehörigen Joche 11 bzw. 21 bestehen aus ferritischem Material, wodurch bei beliebiger Frequenz gearbeitet werden kann. Allerdings ist Ferrit als Kernmaterial mechanisch nicht stark beanspruchbar. Daher ist zwischen den Schenkelkernen 10 und 20 und den sich schließenden Jochen 11 und 21 ein Luftspalt gelassen, was den Vorteil hat, daß Staub und Schmutzpartikel, die sich zwischen Joch und Kern absetzen, keinen störenden Einfluß auf das Ergebnis haben. Mit zunehmender Luftspaltlänge nimmt der Fehlerparameter $\alpha$, der als das Verhältnis der Meßspannungen einer Spule mit einem Windungsschluß zu einer Spule ohne Windungsschluß ($\alpha = U_{mw} / U_m$) definiert ist, ab. Daher ist es sinnvoll, einen möglichst kleinen Luftspalt zu wählen. Es hat sich gezeigt, daß ein günstiger Kompromiß ein Luftspalt von 0,2 mm ist.

Der Abstand 15 der beiden zueinandergewandten Schenkel der Schenkelkerne 10 und 20 kann variiert werden und wird in Abhängigkeit von den Abmessungen des Prüflings gewählt. Ein Prüfling 1 ist auf die benachbarten Schenkel aufgeschoben.

Auf dem ersten Schenkelkern 10 befindet sich eine Erregerspule 5, die an einen Generator 6 vorbestimmbarer Frequenz angeschlossen ist. Auf dem zweiten Schenkelkern 20 befindet sich eine Meßspule 25, die mit einem Spannungsmeßgerät 26 verbunden ist.

Wenn an der Einrichtung gemäß FIG 1 die Frequenz variiert und das Response-Signal gemessen wird, ergibt sich in Abhängigkeit von der Meßfrequenz eine Kurve, deren qualitativer Verlauf in FIG 2 dargestellt ist: Aufgetragen ist das Signal $U_a = g(f)$ mit der Meßspannung U als Ordinate und der Frequenz f als Abszisse in willkürlichen Einheiten. Man erkennt, daß das Signal $U_a = g(f)$ entsprechend Graph 32 zwar mit der Frequenz variiert, bei einem bestimmten Wert aber ein deutliches Minimum durchläuft. Diese Frequenz ist vom Prüflingstyp abhängig und kann im Bereich zwischen 500 Hz und 100 kHz liegen. Der Graph 33 zeigt die Ausgangsspannung $U_a$ bei einem mit einem Windungsschluß behafteten Prüfling.

Theoretischen Betrachtungen ist zu entnehmen, daß bei einer beliebigen Spule als Prüfling in Abhängigkeit von deren Induktivität L und Kapazität $C_L$ einerseits und den geometrischen Verhältnissen der Meßvorrichtung andererseits das von der Erregerspule ausgehende Streufeld und daß durch die Windungskapazität verursachte Streufeld des Prüflings 1 sich gegenseitig in der Meßspule kompensieren können. Die Schwankungsbreiten der Induktivität L und der Spulenkapazität $C_L$ hängen von der unvermeidbaren Toleranz der Windungszahl, der Spulenkörperabmessungen und der Drahtstärke ab, so daß auch die Meßfrequenz prüflingsabhängig ist. Da die genannten Toleranzbereiche ermittelt werden können, liegt die optimale Meßfrequenz in einem vorbestimmbaren Meßfrequenzbereich. Sofern die Kerngeometrie konstant bleibt, ergibt sich dadurch ein geeigneter Meßfrequenzbereich allein in Abhängigkeit vom Prüfling. Da nunmehr die Messung in einem Meßfrequenzbereich erfolgt und der Wert der minimalen Spannung in diesem Frequenzbereich ausgewertet wird, ist sichergestellt, daß unabhängig von den Prüflingstoleranzen bei der für die jeweils angeschlossenen Prüfling optimalen Frequenz gemessen wird. Ein weiterer Abgleich ist nicht notwendig.

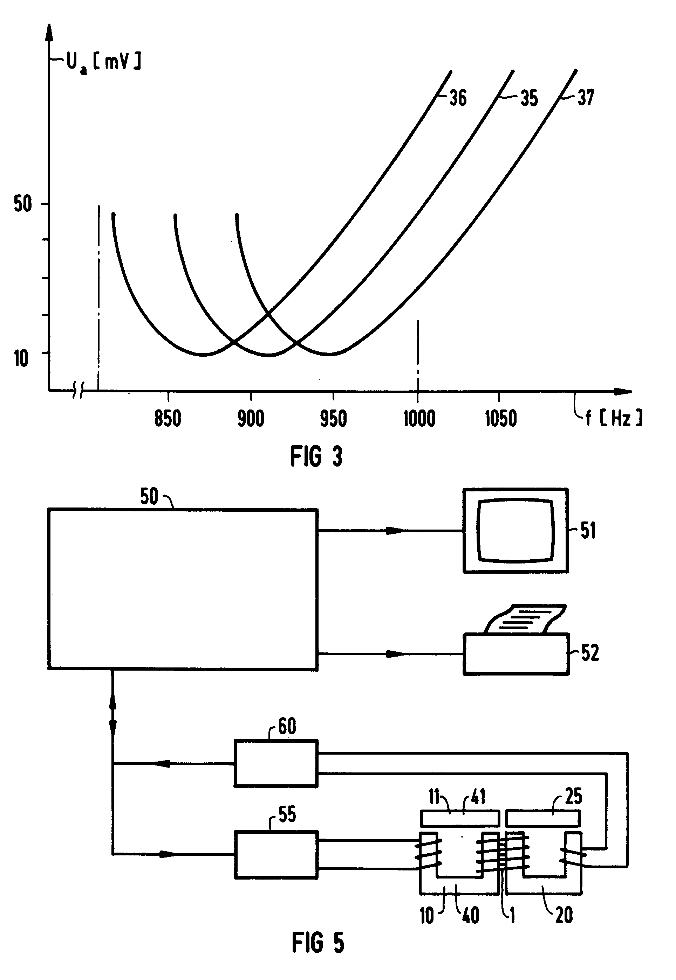

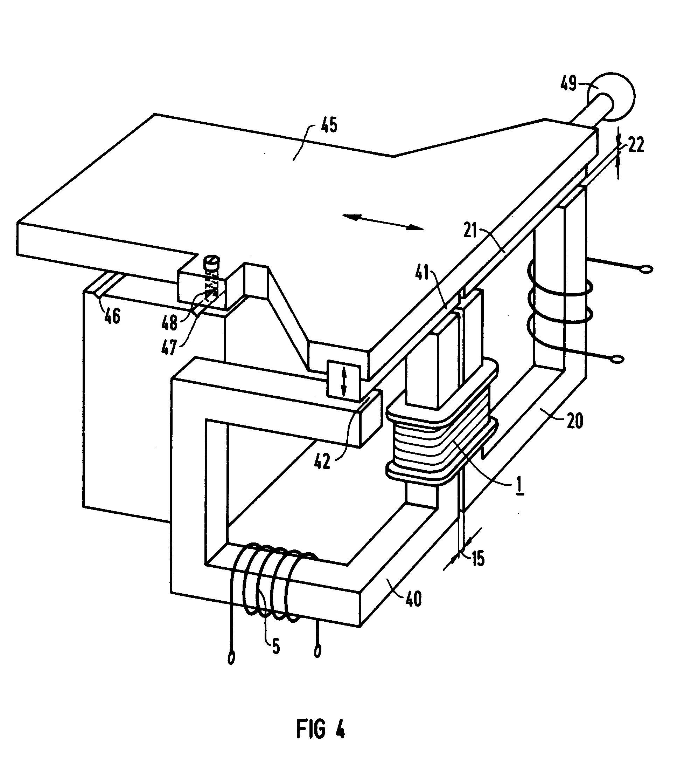

FIG 3 zeigt einen Ausschnitt aus FIG 2 in Anwendung einer Spule vom Typ 3 Th 2 mit einer Windungszahl von n = 30.000. Beispielsweise liegt hier das Minimum der Normalspule bei etwa f = 910 Hz entsprechend Graph 35, was die optimale Meßfrequenz $f_{opt}$ darstellt. Wird L oder $C_L$ des Prüflings 1 größer, verschiebt sich $f_{opt}$ zu niedrigeren Frequenzen entsprechend Graph 36; wird L oder $C_L$ kleiner, verschiebt sich $f_{opt}$ dagegen zu höheren Frequenzen entsprechend Graph 37, wobei aber in beiden Fällen der Absolutwert des Minimums bleibt. Durch einen Lagen- und /oder Windungsschluß verändert sich dagegen auch der Absolutwert der Spannung im Minimum entsprechend Graph 33 aus FIG 2. Der für das Beispiel angepaßte Meßfrequenzbereich reicht also von etwa 800 bis 1000 Hz.

Die Graphen 36 und 37 in FIG 2 stellen Grenzwerte für die minimale bzw. maximale Induktivität und Kapazität dar. Alle in der Praxis vorkommenden Spulen des genannten Types liegen im Bereich dieser Grenzkurven.

Da sich unter Umständen verschiedene Effekte überlagern können, muß für eine Serienprüfung zunächst einmalig an einer Normalspule, die dem Prüflingstyp nahekommt, die optimale Meßfrequenz ermittelt werden. Bei der Messung wird dann die Meßfrequenz variiert, gleichzeitig die Ausgangsspannung gemessen und jeweils der Wert der minimalen Spannung ausgewertet. Im optimalen Meßbereich kann dann der Absolutwert des Minimums der Meßspannung eindeutig anzeigen, ob ein Windungsschluß vorliegt oder nicht.

Bei einem Meßaufbau gemäß FIG 1 ist allerdings nicht völlig auszuschließen, daß aus der Erregerspule 5 ein Teilfeld unmittelbar in die Meßspule 25 einstreut. Um diesen Störeffekt zu minimieren, hat es sich als vorteilhaft erwiesen, das Magnetfeld der Erregerspule 5 senkrecht zur magnetischen Achse der Meßspule anzuordnen, so daß aus physikalischen Gründen durch direkte Einstreuungen eines Magnetfeldes der Erregerspule überhaupt keine Spannungen in die Meßspule induziert werden können. Hierfür müssen die Schenkelkerne geometrisch derart ausgebildet werden, daß einer der beiden Schenkelkerne 10 oder 20 entsprechend verschränkt ist

Gemäß FIG 4 ist speziell ein Schenkelkern 40 mit Joch 41 des Erregerkreises mit einem Winkel von 90° abgewinkelt. Ansonsten ist der Meßaufbau identisch wie in FIG 1.

Für die Serienprüfung von Spulen mit einem Meßaufbau gemäß FIG 1 oder FIG 4 ist es notwendig, jeweils die Joche 11, 21, 41 über den Schenkelkernen 10, 20, 40 zu öffnen und nach Einlegen des Prüflings definiert zu schließen. Hierfür kann ein Schlitten 45 mit einer Verriegelungseinrichtung vorgesehen sein, die durch Kugelrasten in zwei vorbestimmbaren Positionen 46 oder 47 fixierbar ist. Der Schlitten 45 ist mit der Grundplatte der Vorrichtung verbunden und ermöglicht eine Querverschiebung der beiden Joche 21 und 41 aus der ersten Stellung 46 in die zweite Stellung 47, wo sie jeweils durch Rasten 48 fixiert werden. Mittels eines Betätigungshebels 49 ist die Handhabung der Vorrichtung bei der Serienprüfung vereinfacht.

In FIG 5 ist eine Vorrichtung gemäß FIG 1 oder FIG 4 in ein Meßsystem eingebunden, das im wesentlichen aus einem Personalcomputer (PC) 50 mit zugehörigen Endgeräten, wie einem Monitor 51 und einem Drucker 52, sowie einem frequenzvariablen Oszillator 55 und einem Digitalmultimeter 60 als Spannungsmesser besteht. Der Oszillator 55 dient zur Synthetisierung von frequenzvariablen Spannungen und wird beim Meßablauf durch den PC 50 gesteuert.

Durch geeignete softwaremäßige Vorgabe wird der Prüfablauf in der Weise gesteuert, daß die optimalen Meßparameter selbsttätig an den angeschlossenen Geräten eingestellt werden. Nach dem Start der Messung übernimmt der PC 50 die Aufnahme und Auswertung der Meßwerte und bringt das Endergebnis schließlich zur Anzeige auf dem Monitor 51 bzw. Drucker 52. Neben der Verarbeitung der Meßwerte kann mit dem PC 50 insbesondere eine Speicherung der vorgegebenen Sollwerte erfolgen. Zusätzlich ist im Rahmen einer Massenfertigung eine statistische Auswertung der Meßwerte möglich.

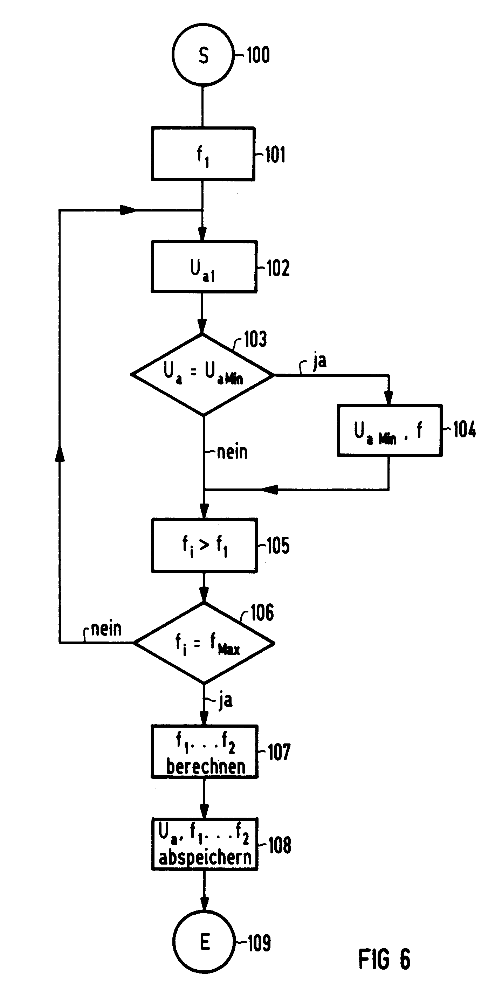

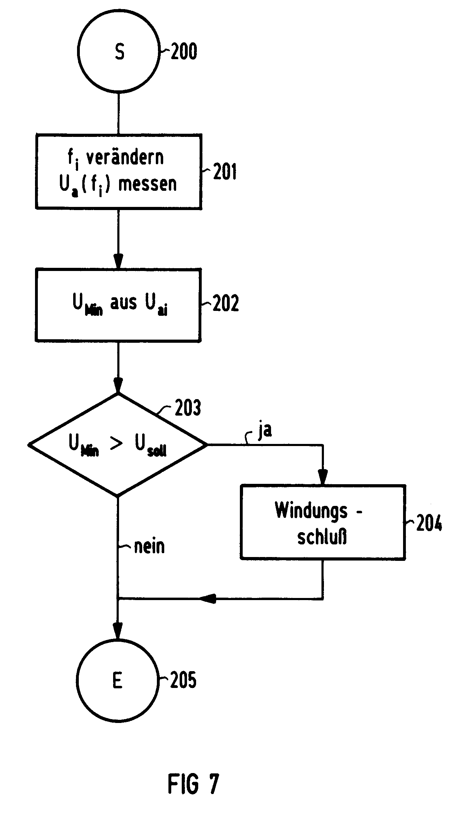

Die Windungsschlußprüfung ist entsprechend den Flußdiagrammen gemäß FIG 6 und FIG 7 dargestellt. Dabei zeigt FIG 6 die einmalige und automatische Ermittlung der optimalen Meßparameter, dagegen FIG 7 die eigentliche Meßsequenz, die für jeden Prüfling bei der Serienfertigung durchgeführt wird. Dabei sind entsprechend üblicher Praxis Ablaufschritte mit Rechtecken und Entscheidungsschritte mit Rauten gekennzeichnet.

Die Darstellung in FIG 6 geht von der Annahme aus, daß die Frequenzgrenzen, d. h. die niedrigste Meßfrequenz wie z. B. 500 Hz bzw. die höchste Meßfrequenz wie z. B. 100 kHz für den Prüflingstyp vorgegeben sind. Nach dem Start gemäß Position 100 wird in dem Ablaufschritt 101 die Sendespule mit der niedrigsten Meßfrequenz f1 erregt. Anschließend wird in Schritt 102 die Spannung an der Meßspule aufgenommen und bei Entscheidungsschritt 103 geprüft, ob es sich bei der aufgenommenen Spannung um das gesuchte Minimum handelt. Ist dies nicht der Fall, wird die Meßfrequenz gemäß Position 105 erhöht. Ist dies dagegen der Fall, wird die aktuell eingestellte Meßfrequenz und der minimale Spannungswert $Ua_{min}$ Speicher festgehalten und ebenfalls - wie im ersten Fall - die Meßfrequenz erhöht.

Nach Erhöhung der Meßfrequenz wird im Entscheidungsschritt gemäß Position 106 geprüft, ob die maximale Frequenz erreicht ist. Ist dies nicht der Fall, wird wieder zur Position 103 zurückgegangen und eine entsprechende Schleife durchlaufen. Ist dagegen die maximale Frequenz erreicht, wird gemäß Ablaufschritt 107 mit der gespeicherten Meßfrequenz und den zugehörigen Spannungswerten ein optimaler Bereich mit Meßfrequenzen von f1 bis f2 berechnet und gemäß Ablaufschritt 108 dieser Meßfrequenzbereich mit zugehöriger minimaler Spannung als Sollwerte abgespeichert. Bei Position 109 ist die erste Teilsequenz beendet.

In der Meßsequenz gemäß FIG 7 wird mit Position 200 gestartet und beim Ablaufschritt 201 die Meßfrequenz von f1 bis f2 kontinuierlich erhöht und gleichzeitig jeweils der zugehörige Meßwert aufgenommen. Im Ablaufschritt 202 wird aus den aufgenomenen Meßwerten das Minimum ermittelt und im Entscheidungsschritt 203 das ermittelte Minimum mit dem vorgegebenen Sollwert verglichen. Ist der Meßwert größer als der Sollwert wird gemäß Ablaufschritt 204 ein Windungsschluß festgestellt. Bei Position 205 wird die Messung beendet.

Eine Serienprüfung von Spulen nach den Flußdiagrammen gemäß FIG 7 kann in verschiedener Hinsicht modifiziert werden, was durch Software-Änderungen ohne weiteres möglich ist. In jedem Fall erhält der Benutzer der erfindungsgemäßen Vorrichtung am Monitor 51 des PC 50 unmittelbar eine Aussage über die Qualität der Spule und das eventuelle Vorliegen eines Windungsschlusses.

Durch die vollautomatisierte Messung kann die Serienprüfung von Spulen auch von ungeschultem Personal einwandfrei durchgeführt werden. Da keine hohen Spannungen am Prüfling auftreten, kann der sicherheitstechnische Aufwand gering gehalten werden. Obwohl die unvermeidbaren Fertigungstoleranzen der Prüflingsspulen keinen Einfluß auf das Meßergebnis haben und jeder Prüfling bei den für ihn optimalen Meßparametern geprüft wird, ist die Meßzeit kurz.

Da ein PC zur Prüfablaufsteuerung verwendet wird, können alle anfallendebn Meßwerte leicht einer statistischen Auswertung unterzogen werden.

## Patentansprüche

1. Windungs- und/oder Lagenschlußprüfverfahren für Spulen, bei dem durch eine Erregerwicklung (5) in einem Erregerkreis (10) in die zu prüfende Spule (Prüfling 1) eine erste Spannung induziert wird, wobei das von einer Windung mit Windungsschluß durch den darin fließenden Kurzschlußstrom erzeugte Streufeld in eine Meßspule (25) eines Meßkreises eine zweite Spannung ($U_a$) induziert, deren Wert und/oder Phase gegenüber einem Vergleichswert ermittelbar ist, wobei die Messung bei einer solchen Frequenz ($f_i$),bei der die Spannung ($U_a$) in der Meßspule (25) bei fehlerfreiem Prüfling (1) Null ist, ausgeführt wird, **dadurch gekennzeichnet,** daß die Meßfrequenz ($f_i$) innerhalb eines prüflingstypspezifischen Meßfrequenzbereiches ($f_i$, i = 1,2, ...) liegt, der aus einem Frequenzspektrum zwischen etwa 500 Hz und etwa 100 kHz ermittelt wird, wobei die Meßfrequenz ($f_i$) im Meßfrequenzbereich ($f_i$, i = 1,2, ...) variiert und gleichzeitig die Spannung ($U_a$) an der Meßspule (25) aufgenommen wird, und daß jeweils der Wert der minimalen Spannung ($U_{aMin}$) ausgewertet wird.

2. Verfahren nach Anspruch 1, **dadurch gekennzeichnet,** daß die Meßfrequenz ($f_i$) in Abhängigkeit von der Länge eines Luftspaltes (15) im Erreger- und Meßkreis einerseits und von der Induktivität (L) und Kapazität ($C_L$) des Prüflings (1) andererseits gewählt wird.

3. Verfahren nach Anspruch 1 oder 2, **dadurch gekennzeichnet,** daß die optimale Meßfrequenz ($f_{opt}$) innerhalb des Meßfrequenzbereiches ($f_i$, i = 1,2, ...) mit Hilfe einer Normalspule, die dem Prüflingstyp nahekommt, ermittelt wird.

4. Verfahren nach Anspruch 3, **dadurch gekennzeichnet,** daß der Wert der minimalen Spannung ($U_a$) des Prüflings (1) mit dem Wert der minimalen Spannung der Normalspule verglichen wird.

5. Vorrichtung zur Durchführung des Windungs- und/oder Lagenschlußprüfverfahrens nach Anspruch 1 oder einem der Ansprüche 2 bis 4, mit einem ersten Schenkelkern (10, 40) mit einer Erregerwicklung (5) und mit einem weiteren Schenkelkern (20) mit einer Meßwicklung (25) und daran angeschlossener Anzeigeeinrichtung (26) in derartiger Anordnung, daß die Schenkel der beiden Schenkelkerne (10, 40; 20) von der zu prüfenden Wicklung (1) umgreifbar sind, wobei beide Schenkelkerne (10, 20) durch ein Joch (11, 21) schließbar sind und zwischen den Schenkelkernen und dem sie jeweils schließenden Joch (11, 21, 41) ein Luftspalt (12, 22, 42) besteht, **dadurch gekennzeichnet,** daß die Schenkelkerne (10; 20, 40) und die sie schließenden Joche (11, 21; 41) aus Ferrit bestehen, daß Mittel vorhanden sind, die die Meßfrequenz variieren und gleichzeitig die Spannung ($U_a$) an der Meßspule (25) aufnehmen und daß weitere Mittel vorgesehen sind, mit denen jeweils der Wert der minimalen Spannung in der Meßspule (25) ausgewertet wird.

6. Vorrichtung nach Anspruch 5, **dadurch gekennzeichnet,** daß der Luftspalt (12, 22, 42) zwischen Kern (10, 20, 40) und Joch (11, 21, 41) größer als 0,1 mm ist, vorzugsweise bei 0,2 mm liegt.

7. Vorrichtung nach Anspruch 5, **dadurch gekennzeichnet,** daß das Magnetfeld der Erregerspule (5) senkrecht zur magnetischen Achse der Meßspule (25) angeordnet ist.

8. Vorrichtung nach Anspruch 7, **dadurch gekennzeichnet,** daß der Schenkelkern (40) des Erregerkreises um 90° abgewinkelt ausgebildet ist.

9. Vorrichtung nach Anspruch 5, **dadurch gekennzeichnet,** daß jedes der beiden, die Schenkelkerne (10, 20, 40) jeweils schließenden Joche (11, 21, 41) in vorbestimmter Position durch eine Verriegelungseinrichtung (45 bis 48) verriegelbar ist.

10. Vorrichtung nach Anspruch 8, **dadurch gekennzeichnet,** daß die Verriegelungseinrichtung durch Kugelrasten (48) in zwei vorbestimmbaren Positionen (46, 47) fixierbar ist.

11. Vorrichtung nach Anspruch 5, **gekennzeichnet durch** die Zuordnung eines Personalcomputers (50) zur Ablaufsteuerung, Auswertung der Meßwerte und Anzeige der Ergebnisse.

**Claims**

1. Method for testing coils for interturn and/or interlayer faults, in which a first voltage is induced in the coil to be tested (test piece 1) by means of an excitation winding (5) in an excitation circuit (10), whereby the stray field generated by a winding having an interturn fault as a result of the short circuit current flowing through it, induces a second voltage ($U_a$) in a measuring coil (25) of a measuring circuit, the value and/or phase of which second voltage can be determined relative to a comparison value, the measurement being carried out at a frequency ($f_i$) at which the voltage ($U_a$) in the measuring coil (25) is zero when the test piece (1) is free from faults, characterised in that the measuring frequency ($f_i$) is within a measuring frequency range ($f_i$, i = 1,2...) for the specific test piece type, this measuring frequency range being determined from a frequency spectrum between approximately 500 Hz and approximately 100 kHz, whereby the measuring frequency ($f_i$) varies within the measuring frequency range ($f_i$, i = 1,2...) and at the same time the voltage ($U_a$) is recorded at the measuring coil (25), and in that the respective value of the minimum voltage ($U_{aMin}$) is evaluated.

2. Method according to claim 1, characterised in that the measuring frequency ($f_i$) is selected in dependence upon the length of an air gap (15) in the excitation and measuring circuit, on the one hand, and upon the inductance (L) and capacitance ($C_L$) of the test piece (1), on the other hand.

3. Method according to claim 1 or 2, characterised in that the optimum measuring frequency ($f_{opt}$) within the measuring frequency range ($f_i$, i = 1,2...) is determined with the aid of a standard coil which approximates the test piece type.

4. Method according to claim 3, characterised in that the value of the minimum voltage ($U_a$) of the test piece (1) is compared with the value of the minimum voltage of the standard coil.

5. Device for carrying out the method for testing for interturn and/or interlayer faults according to claim 1 or one of claims 2 to 4, using a first U-shaped core (10, 40) having an excitation winding (5) and using a further U-shaped core (20) having a measuring winding (25) and a display device (26) connected thereto in an arrangement such that the winding (1) to be tested can wrap around the arms of the two U-shaped cores (10, 40; 20), whereby the two U-shaped cores (10, 20) can be closed by means of a yoke (11, 21), and an air gap (12, 22, 42) exists between the U-shaped cores and the respective yoke (11, 21, 41) closing them, characterised in that the U-shaped cores (10; 20, 40) and the yokes (11, 21; 41) closing them are composed of ferrite, in that there are means which vary the measuring frequency and record the voltage ($U_a$) at the measuring coil (25) at the same time, and in that there are provided further means by which the respective value of the minimum voltage in the measuring coil (25) is evaluated.

6. Device according to claim 5, characterised in that the air gap (12, 22, 42) between the core (10, 20, 40) and the yoke (11, 21, 41) is greater than 0.1 mm and is preferably 0.2 mm.

7. Device according to claim 5, characterised in that the magnetic field of the excitation coil (5) is arranged perpendicularly to the magnetic axis of the measuring coil (25).

8. Device according to claim 7, characterised in that the U-shaped core (40) of the excitation circuit is bent at an angle of 90°.

9. Device according to claim 5, characterised in that each of the two yokes (11, 21, 41) closing the U-shaped cores (10, 20, 40), respectively, can be locked in a pre-determined position by means of a locking device (45 to 48).

10. Device according to claim 8, characterised in that the locking device can be fixed in two pre-determined positions (46, 47) by means of ball notches (48).

11. Device according to claim 5, characterised by the assignment of a personal computer (50) for sequencing control, evaluation of the measured values and display of the results.

**Revendications**

1. Procédé de contrôle de courts-circuits de spires et/ou de couches pour des bobines, selon lequel un enroulement d'excitation (5) d'un circuit excitateur (10) induit, dans la bobine à contrôler (objet à contrôle 1) une première tension, le champ de fuite produit par une spire comportant un court-circuit sous l'effet du courant de court-circuit circulant dans cette spire, induit dans une bobine de mesure (25) d'un circuit de mesure, une seconde tension ($U_a$),dont la valeur et/ou la phase peut être déterminée par rapport à une valeur de référence, la mesure étant effectuée à une fréquence ($f_i$) telle que la tension ($U_a$) dans la bobine de mesure (25) est nulle dans le cas où l'objet à contrôler (1) est sans défaut, caractérisé par le fait que la fréquence de mesure (fi) est dans une gamme de fréquences de mesure ($f_i$, i = 1, 2, ...), qui est spécifique au type d'objet à contrôler et qui est déterminée à partir d'un spectre de fréquence compris entre environ 500 Hz et environ 100 Hz, la fréquence de mesure ($f_i$) étant modifiée dans la gamme de fréquence de mesure ($f_i$, i = 1, 2, ...) tandis que simultanément la tension ($U_a$) aux bornes de la bobine de mesure (24) est enregistrée, et que respectivement la valeur de la tension minimale ($U_{aMin}$) est évaluée.

2. Procédé suivant la revendication 1, caractérisé par le fait que la fréquence de mesure ($f_i$) est

choisie d'une part en fonction de la longueur d'un entrefer (15) du circuit d'excitation et de mesure et d'autre part en fonction de l'inductance (L) et de la capacité ($C_L$) de l'objet à contrôler (1).

3. Procédé suivant la revendication 1 ou 2, caractérisé par le fait que la fréquence optimale de mesure ($f_{opt}$) est déterminée dans la gamme des fréquence de mesure ($f_i$, i = 1, 2, ...), à l'aide d'une bobine normale, qui se rapproche du type d'objet à contrôler.

4. Procédé suivant la revendication 3, caractérisé par le fait que la valeur de la tension minimale ($U_a$) de l'objet à contrôler (1) est comparée à la valeur de la tension minimale de la bibine normale.

5. Dispositif pour la mise en oeuvre du procédé de contrôle de courts-circuits de spires et/ou de couches suivant la revendication 1 ou l'une des revendications 2 à 4, comportant un premier noyau à branches (10, 40) comportant un enroulement d'excitation (5), et un autre noyau à branches (20) comportant un enroulement de mesure (25) et auquel est raccordé un dispositif d'affichage (26), selon une disposition telle que les branches des deux noyaux à branches (10, 40, 20) peuvent être entourées de l'enroulement à contrôler (1), les deux noyaux à branches (10, 20) pouvant être fermés par une culasse (11, 21), tandis qu'un entrefer (12, 22, 42) est présent entre les branches des noyaux et la culasse (11, 21, 41), qui les ferme respectivement, caractérisé par le fait que les noyaux à branches (10, 20, 40) et les culasses (11, 21, 41), qui les ferment sont en ferrite, qu'il est prévu des moyens destinés à faire varier la fréquence de mesure et à enregistrer simultanément la tension (Ua) aux bornes de la bobine de mesure (25), et qu'il est prévu d'autres moyens destinés à évaluer la valeur de la tension minimale dans la bobine de mesure (25).

6. Dispositif suivant la revendication 5, caractérisé par le fait que l'entrefer (12, 22, 42) entre le noyau (10, 20, 40) et la culasse (11, 21, 41) est supérieur à 0,1 mm et est égale de préférence à 0,2 mm

7. Dispositif suivant la revendication 5, caractérisé par le fait que le champ magnétique de la bobine d'excitation (5) est perpendiculaire à l'axe magnétique de la bobine de mesure (25).

8. Dispositif suivant la revendication 7, caractérisé par le fait que le noyau à branches (40) du circuit d'excitation est coudé à 90°.

9. Dispositif suivant la revendication 5, caractérisé par le fait que chacune des deux culasses (11, 21, 41), qui ferme respectivement les noyaux à branches (10, 20, 40), peut être verrouillée dans une position déterminée à l'avance par un dispositif de verrouillage (45 à 48).

10. Dispositif suivant la revendication 8, caractérisé par le fait que le dispositif de verrouillage peut être fixé par des systèmes d'encliquetage à billes (48), dans deux positions (46, 47) déterminées à l'avance.

11. Dispositif suivant la revendication 5, caractérisé par l'association d'un ordinateur personnel (50) pour la commande d'excécution, l'évaluation des valeurs de mesure et l'affiche des résultats.

FIG 1

$U_a = g(f)$

FIG 2

FIG 3

FIG 5

**FIG 4**

FIG 6

$S$ — 200

$f_i$ verändern
$U_a(f_i)$ messen — 201

$U_{Min}$ aus $U_{ai}$ — 202

203

$U_{Min} > U_{soll}$ — ja

nein

Windungs -
schluß — 204

$E$ — 205

FIG 7